# EUROPEAN PATENT SPECIFICATION

(11) **EP 1 756 360 B1**
(45) Date of publication and mention of the grant of the patent: **15.08.2012**
(21) Application number: 05739774.7
(22) Date of filing: 15.04.2005
(51) Int. Cl.: D21H 13/26

(54) **ARAMID PAPER BLEND**
ARAMIDFASERMISCHUNG
MELANGE DE PAPIER A BASE D'ARAMIDE

(30) Priority: 16.04.2004 US 826530
(43) Date of publication of application: 28.02.2007
(73) Proprietor: E.I. DU PONT DE NEMOURS AND COMPANY, Wilmington, DE 19898 (US)
(72) Inventor: LEVIT, Mikhail, R., Glen Allen, Virginia 23059 (US)
(74) Representative: Morf, Jan Stefan
(86) International application number: PCT/US2005/012996
(87) International publication number: WO 2005/103376

(56) References cited:
- EP-A- 0 739 707
- EP-A- 1 152 084
- WO-A-95/17549
- US-A- 4 729 921
- US-A- 5 026 456
- US-A- 5 833 807

## Description

### BACKGROUND OF THE INVENTION

### 1. Field of the Invention

This invention relates to aramid paper suitable for composite structures.

### 2. Description of Related Art

History of aramid papers can be tracked from U.S. Patent No. 2,999,788, issued to Morgan on September 12, 1961, which discloses papers based on fibrids from synthetic polymers including papers from aromatic polyamide (aramid) fibrids and their combination with different fibers.

In the following years, many types of paper and pressboard based on aramid fibrids, aramid floc, aramid pulp, other ingredients and their combinations were described.

U.S. Patent Nos. 4,698,267 and 4,729,921, both to Tokarsky, disclose high density p-aramid papers, which comprise p-aramid floc, p-aramid pulp or their blend and, optionally, 5-15% of polymeric binder including aramid fibrids.

U.K. Research Disclosure V338(073)(Anonymous), issued 1992, discloses aramid fiber containing sheets with 40-60% by weight of m-aramid fibrids, 0-30% by weight of m-aramid floc, 0-60% by weight of p-aramid floc, and 0-40% by weight of p-aramid pulp.

U.S. Patent No. 5,026,456 to Hesler et al. discloses a high porosity paper comprising 10-40% by weight of aramid fibrids, 5-30% by weight of high temperature resistant floc, and 30-85% by weight of aramid paper pulp prepared by comminuting dry aramid paper containing 50 to 60% aramid fibrids and 40 to 50% aramid floc to a particle size capable of passing through a sorting screen of 6.4-12.7 mm. More specifically, the high porosity paper of this invention comprises previously-dried aramid fibrids and previously-dried aramid floc from aramid paper pulp and, also, fresh aramid fibrids and fresh high temperature resistant floc.

U.S. Patent No. 5,789,059 to Nomoto discloses a honeycomb core made from a base sheet a mixture of p-aramid fibers (floc) and m-aramid pulp wherein p-aramid fiber occupies of from not less than 20% to less than 50% by weight of the mixture.

### BRIEF SUMMARY OF THE INVENTION

This invention relates to aramid paper for composite structures, which comprises 50 to 95 weight percent p-aramid pulp, 5-50 weight percent of floc of meta-aramid with initial modulus lower than 3000 cN/tex, and, optionally, less than 20 weight percent of polymer binder material. The invention is also directed to a process for making the paper.

### DETAILED DESCRIPTION OF THE INVENTION

Aramid papers find use, among others, as a basic material for honeycomb cores, a reinforcement for printed circuit boards and other laminate structures, an electrical insulation in oil or resin-filled systems, as a basic material for friction facings in automotive industry, and in other applications of high performance composite structures. For higher stiffness, strength, better dimensional stability and abrasion resistance of a final composite structure, such papers should preferably contain p-aramid fibrous components.

For acceptable uniformity, papers with p-aramid floc in the composition are formed from very dilute slurries (0.01-0.05 wt.%), which require a usage of special machines for wet-laid nonwovens (inclined wire and others). Paper containing only p-aramid pulp as the aramid component can be formed uniformly on a regular horizontal papermaking machine, such as a Fourdrinier, from medium diluted slurries (0.2-0.6 wt.%). However, aramid paper based only on pulp does not have enough strength to be produced stably at a relatively low basis weight (e.g., below 70 g/m²) and to be processed successfully into a final structure. Addition of any quantity of p-aramid floc to p-aramid pulp significantly reduces the uniformity of the sheet formed on the Fourdrinier machine and requires the aforementioned special machines for uniform formation. Also, addition of p-aramid floc to the paper composition makes the paper much stiffer, which can require special methods to avoid problems in processing into a final composite structure, as it is described, for example, in U.S. Patent No. 6,592,963.

I have found that a combination of 50-95% by weight of p-aramid pulp, 5-50% by weight of floc of meta-aramid having an initial modulus lower than 3000 cN/tex and optionally, less than 20% by weight of polymer binder material provides a paper composition, which can be processed stably and uniformly on a Fourdrinier type papermaking machine into a final paper. Such paper, with a basis weight below 70 g/m², can exhibit a stiffness comparable to that of m-aramid papers.

Further, after resin impregnation to form a composite paper structure, mechanical properties (strength and stiffness) can be achieved that are much higher than those achieved with an m-aramid composition. Such composite paper structure can approach the properties achieved in compositions with p-aramid floc. In fact, the composite paper structure of this invention exhibits an increase in stiffness of 4-5 times in contrast to less than 2 times for commercial meta-aramid papers or para-aramid papers based on para-aramid floc. Resins for impregnating the paper to form the composite paper structure include polyamides, polyimides, epoxies, phenolics, polyesters, polyurethanes and others equally suitable.

With an optimized composition, the paper of this invention can exhibit lower changes in dimensions with a change in temperature (i.e., a lower coefficient of thermal expansion) in comparison with commercial papers based on para- or meta-aramid papers for honeycombs.

By "floc" is meant fibers having a length of 2 to 25 millimeters preferably 3 to 7 millimeters and a diameter of 3 to 20 micrometers, preferably 5 to 14 micrometers. If the floc length is less than 3 millimeters, its impact on the paper strength is not high enough and if it is more than 25 millimeters, it is almost impossible to form a uniform web by a wet-laid method. If the floc diameter is less than 5 micrometers, it can be difficult to produce it with enough uniformity and reproducibility and if it is more than 20 micrometers, it is virtually impossible to form uniform paper of light to medium basis weights. Floc is generally made by cutting continuous spun filaments into specific-length pieces. A preferred type of the floc in this invention is meta-aramid floc and, particularly, floc from poly(metaphenylene isophthalamide). However, floc from other materials with an initial modulus lower than 3000 cN/tex can be used, for example, poly (ethylene terephthalate), polyacrylonitrile, etc.

The term "pulp", as used herein, means particles of aramid material having a stalk and fibrils extending generally therefrom, wherein the stalk is generally columnar and about 10 to 50 micrometers in diameter and the fibrils are fine, hair-like members generally attached to the stalk measuring only a fraction of a micrometer or a few micrometers in diameter and about 10 to 100 micrometers long.

The term "fibrids" as used herein, means a very finely-divided polymer product of small, filmy, essentially two-dimensional, particles known having a length and width on the order of 100 to 1000 micrometers and a thickness only on the order of 0.1 to 1 micrometer. Fibrids are made by streaming a polymer solution into a coagulating bath of liquid that is immiscible with the solvent of the solution. The stream of polymer solution is subjected to strenuous shearing forces and turbulence as the polymer is coagulated.

"Aramid" materials are polyamides wherein at least 85% of the amide (-CO-NH-) linkages are attached directly to two aromatic rings. Additives can be used with the aramid and it has been found that up to as much as 10 percent, by weight, of other polymeric material can be blended with the aramid. Copolymers can be used having as much as 10 percent of other diamines substituted for the diamine of the aramid or as much as 10 percent of other diacid chlorides substituted for the diacid chloride of the aramid.

Floc, p-aramid pulp and a polymer binder material in the paper of this invention can be of natural color or colored by dyes or pigments. The floc and the pulp can be treated by materials which alter their surface characteristics so long as such treatment does not adversely affect the ability of binders to contact and hold to the fiber surfaces.

It has been determined that to achieve higher strength in the papers of this invention that it is preferable to have a polymer binder material in the paper composition in the quantity up to 20% by weight of the total composition, but at least about 3%. If more than 20% by weight of the polymer binder is present in the paper composition it can complicate the impregnation of the paper with resins in the further processing into the final composite structure and exceed necessary level of binder for strengthening purposes.

Aramid fibrids are very effective types of binder. Other polymer binders such as floc, which can be fused during drying or calendering operations, or water-soluble resins, or combinations of different types of polymer binders can be used for this invention. In the case of fusible floc, it performs two functions in the paper composition of this invention in that it works as floc to prevent paper breaks during paper formation and works as a binder after further processing. Depending on the type of polymer binder material and its content in the paper composition, the paper of this invention can have very high permeability, with Gurley air resistance of several seconds, or have medium permeability, with Gurley air resistance up to several thousand seconds.

The preferred material for the fibrids of this invention are generally aramids, specifically, meta-aramids, and, more specifically, poly(m-phenylene isophthalamide). Other suitable fibrid materials are polyacrylonitrile, polycaproamide, poly (ethylene terephthalate), and the like. Fibrids from aramid materials will provide better thermal stability of the paper in comparison with other mentioned materials.

Resin used as a binder can be in the form of a water-soluble or dispersible polymer added directly to the paper making dispersion or in the form of thermoplastic binder fibers of the resin material intermingled with the aramid fibers to be activated as a binder by heat applied during drying or following additional compression and/or heat treatment. The preferred materials for the water-soluble or dispersible binder polymer are water-soluble or water-dispersible thermosetting resins such as polyamide resins, epoxy resins, phenolic resins, polyureas, polyurethanes, melamine formaldehyde resins, polyesters and alkyd resins, generally. Particularly useful are water-soluble polyamide resins, typical for the papermaking industry (e.g., cationic wet-strength resin KYMENE® 557LX and others). Water solutions and dispersion of non-cured polymers can be used as well (poly(vinyl alcohol), poly(vinyl acetate), etc.).

Thermoplastic binder floc can be made from such polymers as poly(vinyl alcohol), polypropylene, polyester and the like and should have a length and diameter similar to those of the floc described above.

Additional ingredients such as fillers for the adjustment of paper conductivity and other properties, pigments, antioxidants, etc in powder or fibrous form can be added to the paper composition of this invention.

The paper of this invention can be formed on equipment of any scale from laboratory screens to commercial-sized papermaking machinery, such as a Fourdrinier or inclined wire machines. The general process involves making a dispersion of p-aramid pulp, floc, and a binder material (if desired) in an aqueous liquid, draining the liquid from the dispersion to yield a wet composition and drying the wet paper composition. The dispersion can be made either by dispersing the fibers and then adding the binder material or by dispersing the binder material and then adding the fibers. The dispersion can also be made by combining a dispersion of fibers with a dispersion of the binder material. The concentration of fibers in the dispersion can range from 0.01 to 1.0 weight percent based on the total weight of the dispersion. The concentration of a binder material in the dispersion can be up to 20 weight percent based on the total weight of solids.

The aqueous liquid of the dispersion is generally water, but may include various other materials such as pH-adjusting materials, forming aids, surfactants, defoamers and the like. The aqueous liquid is usually drained from the dispersion by conducting the dispersion onto a screen or other perforated support, retaining the dispersed solids and then passing the liquid to yield a wet paper composition. The wet composition, once formed on the support, is usually further dewatered by vacuum or other pressure forces and further dried by evaporating the remaining liquid.

A next step, which can be performed if higher density and strength are desired, is calendering one or more layers of the paper in the nip of metal-metal, metal-composite, or composite-composite rolls. Alternatively, one or more layers of the paper can be compressed in a platen press at a pressure, temperature and time, which are optimal for a particular composition and final application. Also, heat-treatment as an independent step before, after or instead of calendering or compression, can be conducted if strengthening or some other property modification is desired without or in addition to densification.

The paper of this invention is useful as a component in structural materials such as core structures or honeycombs. For example, one or more layers of the aramid paper may be used as the primarly material for forming the cells of a honeycomb structure. Alternatively, one or more layers of the aramid paper may be used in the sheets for covering or facing the honeycomb cells or other core materials. Preferably, these laminates are impregnated with a resin such as a phenolic, epoxy, poyimide or other resin. However, in some instances the paper may be useful without any resin impregnation. In addition to structural applications, the paper of this invention is also useful where thermal dimensional stability is desired, such as printed wiring boards; or where dielectric properties are useful, such as electrical insulating material for use in motors, transformers and other power equipment. In these applications, the paper of this invention can be used either with or without impregnating resins, as desired.

### TEST METHODS

Tensile Strength, Modulus, Tensile Stiffness, and Tensile Index were determined for papers and composites of this invention on an Instron-type testing machine using test specimens 2.54 cm wide and a gage length of 18 cm in accordance with ASTM D 828.

Thickness and Basis Weight (Grammage) of papers and composites was determined in accordance with ASTM D 645 and ASTM D 646 correspondingly.

Density (Apparent Density) of papers was determined in accordance with ASTM D 202.

Specific Stiffness of Papers was determined as a mathematical quantity calculated by dividing tensile stiffness of a paper by basis weight of a paper.

Specific Stiffness of Composites was determined as a mathematical quantity calculated by dividing tensile stiffness of a composite by basis weight of a raw paper.

Specific Tensile Index for Composites was determined as a mathematical quantity calculated by dividing tensile strength of a composite by basis weight of a raw paper.

Gurley Air Resistance for papers was determined by measuring air resistance in seconds per 100 milliliters of cylinder displacement for approximately 6.4 square centimeters circular area of a paper using a pressure differential of 1.22 kPa in accordance with TAPPI T 460.

Coefficient of Thermal Expansion in Plane was measured on dried strips of the material with dimensions of about 8.7 mm long and 2 mm wide on a 2940 TMA Instrument at a temperature between 20°C and 100°C with the temperature increasing at 10°C/minute. The loads were 2 grams and 36 grams for the paper and resin paper, respectively. The average of the readings for the machine and cross direction of the paper web was reported as the final number.

### EXAMPLES

### Example 1

An aqueous dispersion was made of never-dried meta-aramid fibrids at a 0.5% consistency (0.5 weight percent solid materials in water). Para-aramid pulp was dispersed in a pulper at 0.2% consistency for 5 minutes. After that the pulp dispersion was added into a tank with the fibrid dispersion. After ten minutes of continued agitation, meta-aramid floc was added. After five additional minutes of agitation, water was added to yield a final consistency of 0.2%. The solid materials were:
Para-aramid pulp - 74%.
Meta-aramid fibrids - 17%
Meta-aramid floc - 9%

The para-aramid pulp was poly (paraphenylene terephthalamide) pulp type 1 F361 (sold by E.I. du Pont de Nemours and Company (DuPont), Wilmington, DE under the trade name KEVLAR®). The meta-aramid fibrids were made from poly(metaphenylene isophthalamide) as described in U.S. Pat No. 3,756,908. The meta-aramid floc was poly(metaphenylene isophthalamide) floc of linear density 0.22 tex (2.0 denier) and length of 0.64 cm with an initial modulus of about 800 cN/tex (sold by DuPont under the trade name NOMEX®). The resulting dispersion was pumped to a supply chest and fed from there to a Fourdrinier machine to make paper with a basis weight of 47.5 g/m². Other properties of the paper are described in the Table 1 below.

### Example 2

A slurry was prepared as in Example 1. A paper with a basis weight of 40.7 g/m² was formed on a Fourdrinier. Other properties of the paper are described in the Table 1 below.

### Comparative Example 3

A slurry was prepared as in Example 1, but without addition of the floc in the composition. The solid materials were:
Para-aramid pulp - 80%.
Meta-aramid fibrids - 20%

The resulting dispersion was pumped to a supply chest and fed from there to a Fourdrinier to make paper with a basis weight of 47.5 and 60 g/m². However, frequent breaks occurred and it was impossible to prepare a continuous sheet.

### Comparative Example 4

Para-aramid pulp as used in Ex. 1 was dispersed in the pulper at 0.2% consistency for 5 minutes. The resulting dispersion was pumped to a supply chest and fed from there to a Fourdrinier to make paper with a basis weight of 50 and 60 g/m². However, frequent breaks occurred and it was impossible to prepare a continuous sheet.

### Example 5

The paper from Example 1 was passed through the nip of a metal-metal calender with a roll diameter of about 20 cm at a temperature of about 300°C and a linear pressure of about 1200 N/cm. Properties of the final paper are shown in Table 1.

### Example 6

The paper from Example 2 was passed through the nip of a metal-metal calender with a roll diameter of about 20 cm at a temperature of about 300°C and linear pressure of about 1200 N/cm.

Properties of the final paper are shown in Table 1.

### Example 7

The paper from Example 1 was compressed for 2 minutes in a platen press at a temperature of about 304°C and a pressure of about 3.45 MPa.

Properties of the final paper are shown in Table 1.

### Example 8

The paper from Example 1 was compressed for 5 minutes in the platen press at a temperature of about 327°C and a pressure of about 10.8 MPa.

Properties of the final paper are shown in Table 1.

### Example 9

1.5 g (based on dry weight) of para-aramid pulp was placed in a Waring Blender with 800 ml of water and agitated for 3 min. After that, 34.5 g of an aqueous, never-dried, meta-aramid fibrid slurry (0.58% consistency and freeness 330 ml of Shopper-Riegler), the prepared water dispersion of the para-aramid pulp from the Waring Blender and 0.3 g of meta-aramid floc were placed together in a laboratory mixer (British pulp evaluation apparatus) with about 1600 g of water and agitated for 1 min.

The solid materials in the slurry were:
Para-aramid pulp - 75%
Meta-aramid floc - 15%
Meta-aramid fibrids - 10%

The para-aramid pulp, the meta-aramid floc and meta-aramid fibrids were the same as described in Example 1. The dispersion was poured, with 8 liters of water, into an approximately 21 x 21 cm handsheet mold and a wet-laid sheet was formed. The sheet was placed between two pieces of blotting paper, hand couched with a rolling pin and dried in a handsheet dryer at 190°C.

After drying, the sheet was passed through the nip of a metal-metal calender with a roll diameter of about 20 cm at a temperature of about 270°C and a linear pressure of about 3000 N/cm.

The final paper had a basis weight of 56.6 g/m².

Other properties of the paper are described in the Table 1 below.

### Examples 10-13

The papers were prepared as described in Example 9, but with varying percentages of the three components (para-aramid pulp, meta-aramid floc, and meta-aramid fibrids).

The percentages of the components of the paper compositions and their properties are shown in Table 1.

### Example 14

1.2 g (based on dry weight) of para-aramid pulp was placed in a Waring Blender with 800 ml of water and was agitated for 3 min. After that, the prepared water dispersion of the para-aramid pulp, 0.3 g of poly (vinyl alcohol) floc and 0.5 g of meta-aramid floc were placed together in a laboratory mixer (British pulp evaluation apparatus) with about 1600 g of water and agitated for 1 min.

The solid materials in the slurry were:
Para-aramid pulp - 60%
Meta-aramid floc - 25%
Poly (vinyl alcohol) floc - 15%

The para-aramid pulp and the meta-aramid floc were the same as described in Example 1. Poly (vinyl alcohol) floc was type VPB105-1 with linear density 0.11 tex and cut length 3 mm (sold by KURARAY Co. under trade name Kuralon VP). Its initial modulus was lower than 530 cN/tex as found in R.W. Moncrieff, Man-Made Fibres, Wiley International Division, 1970, p. 488.

The dispersion was poured, with 8 liters of water, into an approximately 21 x 21 cm handsheet mold and a wet-laid sheet was formed. The sheet was placed between two pieces of blotting paper, hand couched with a rolling pin and dried in a handsheet dryer at 190°C. After drying, the sheet was compressed for 5 min. in a platen press at a temperature about 304°C and a pressure about 10.8 MPa.

Properties of the final paper are described in Table 1.

### Examples 15-16

The papers were prepared as in Example 14, but with varying percentages of the three components (para-aramid pulp, meta-aramid floc and poly (vinyl alcohol) floc).

The percentages of the components of the paper compositions and their properties are shown in Table 1.

### Example 17

The paper was prepared as in Example 14, except that a water-soluble resin was added to the paper composition in the quantity of 5 percent by weight based on the total weight of the composition. The water-soluble resin was KYMENE 557LX sold by Hercules. Paper compositions and properties are shown in Table 1.

### Example 18

The paper was prepared as in Example 15, except that the water-soluble resin was added to the paper composition in the quantity of 5 percent by weight based on the total weight of the composition. The resin was the same as in Example 23. Paper compositions and properties are shown in Table 1.

### Example 19

A composite was prepared by impregnation of the paper from Example 5 with a solvent-based phenolic resin (PLYOPHEN 23900 from the Durez Corporation) following by removing any excess resin from the surface with blotting paper and curing in an oven by ramping up the temperature as follows: heating from room temperature to 82°C and holding at this temperature for 15 minutes, increasing the temperature to 121°C and holding at this temperature for another 15 minutes and increasing the temperature to 182°C and holding at this temperature for 60 minutes. Properties of the composite are shown in Table 2.

### Example 20

A composite was prepared as described in Example 19, except that the paper from Example 6 was used. Properties of the composite are shown in Table 2.

### Comparative Example 21

A composite was prepared as described in Example 19 except that a para-aramid paper based on KEVLAR® floc and NOMEX® fibrids, sold by DuPont as KEVLAR® 1.8N636 paper, was used. Properties of the composite are shown in Table 2.

### Comparative Example 22

A composite was prepared as described in Example 19 with a difference that a para-aramid paper based on KEVLAR® floc and NOMEX® fibrids, sold by DuPont as KEVLAR® 2.8N636 paper, was used. Properties of the composite are shown in Table 2.

### Comparative Example 23

A composite was prepared as described in Example 19 with a difference that a meta-aramid paper based on NOMEX® floc and NOMEX® fibrids, sold DuPont as NOMEX® 2T412 paper, was used. Properties of the composite are shown in Table 2.

### Comparative Example 24

A composite was prepared as described in Example 19 except that a meta-aramid paper based on NOMEX® floc and NOMEX® fibrids, sold by DuPont as NOMEX® 3T412 paper was used. Properties of the composite are shown in Table 2.

**Table 1 Properties of Papers**

| Example | Paper composition (wt.%) | | | | | Basis wt. (g/m²) | Thickness (mm) | Density (g/cm³) | Tensile strength (N/cm) | Modulus (MPa) | Gurley air resistance (seconds) |
|---|---|---|---|---|---|---|---|---|---|---|---|
| | P-Aramid Soluble Pulp | M-Aramid Floc | Fibrids | PVA Fiber | Water-Resin | | | | | | |
| 1 | 74 | 9 | 17 | | | 49.8 | 0.136 | 0.37 | 3.76 | 241 | 141 |
| 2 | 74 | 9 | 17 | | | 40.0 | 0.113 | 0.35 | 2.84 | 224 | 91 |
| Comp 3 | 80 | | 20 | | | | | | | | |
| Comp 4 | 74 | | | | | | | | | | |
| 5 | 74 | 9 | 17 | | | 49.2 | 0.061 | 0.80 | 8.50 | 1496 | 2700 |
| 6 | 74 | 9 | 17 | | | 40.0 | 0.046 | 0.86 | 7.80 | 1827 | 1170 |
| 7 | 74 | 9 | 17 | | | 45.4 | 0.102 | 0.45 | 5.25 | 223 | 86 |
| 8 | 74 | 9 | 17 | | | 49.5 | 0.077 | 0.65 | 6.24 | 1112 | 600 |
| 9 | 75 | 15 | 10 | | | 51.2 | 0.048 | 1.06 | 9.04 | 2751 | >300 |
| 10 | 90 | 10 | 0 | | | 51.2 | 0.043 | 1.19 | 6.65 | 2455 | 32.4 |
| 11 | 60 | 30 | 10 | | | 51.2 | 0.053 | 0.97 | 8.96 | 2013 | 112 |
| 12 | 90 | 5 | 5 | | | 51.2 | 0.046 | 1.12 | 7.12 | 2972 | >300 |
| 13 | 75 | 25 | 0 | | | 51.5 | 0.051 | 1.01 | 6.40 | 1751 | 11.8 |
| 14 | 60 | 25 | | 15 | | 44.7 | 0.076 | 0.59 | 16.90 | 1813 | 3.1 |
| 15 | 85 | 0 | | 15 | | 43.7 | 0.116 | 0.38 | 7.74 | 483 | 2.0 |
| 16 | 60 | 35 | | 5 | | 44.7 | 0.083 | 0.54 | 7.84 | 965 | 2.0 |
| 17 | 57 | 23.8 | | 14.2 | 5 | 44.4 | 0.121 | 0.37 | 15.0 | 618 | 0.9 |
| 18 | 80.8 | 0 | | 14.2 | 5 | 44.7 | 0.121 | 0.37 | 9.47 | 362 | 1.7 |

**Table 2 Relative Properties of Papers and Composites**

| Example | Paper type | Specific stiffness of paper ((N/cm)/(g/m2)) | Resin Pick-up (% from paper weight) | Specific stiffness of composite ((N/cm)/(g/m2)) | Specific tensile index of composite ((N/cm)/(g/m2)) | Ratio between specific stiffness of composite and paper | Coefficient of thermal expansion in plane for paper (ppm/C) | Coefficient of thermal expansion in plane for composite (ppm/C) |
|---|---|---|---|---|---|---|---|---|
| 19 | Example 5 | 18.5 | 81.8 | 96.9 | 1.42 | 5.2 | -1 | 4 |
| 20 | Example 6 | 21.0 | 100 | 95.8 | 1.37 | 4.6 | -1 | 4 |
| Comp21 | 1.8N636 | 77.6 | 83.5 | 103.2 | 1.33 | 1.3 | -4 | -2 |
| Comp22 | 2.8N636 | 69.0 | 52.7 | 110.9 | 2.00 | 1.6 | -4 | -2 |
| Comp23 | 2T412 | 29.5 | 44.9 | 42.7 | 0.90 | 1.4 | 24 | 25 |
| Comp24 | 3T412 | 30.3 | 42.9 | 42.8 | 0.86 | 1.4 | 24 | 25 |

As can be seen from Table 2, the stiffness of the inventive paper is less than the stiffness of commercial paper based on p-aramid floc (i.e., comparative examples 21 and 22) and also less than even the papers based on m-aramid (i.e., comparative examples 23 and 24).

However, the composites based on the inventive papers are very stiff, which is desirable for the majority of composite applications. Their stiffness is very close to that of the composites based on the p-aramid papers and much stiffer than that of the composites based on m-aramid paper. This is additionally demonstrated by the ratio between specific stiffness of the composite and the respective papers on which they were based. The ratio is much higher for the inventive paper vs. the comparative papers, demonstrating that "softer" (i.e., less stiff) paper provides for easier conversion into the final composite structure.

Further, the paper of the invention and corresponding composites have very good dimensional stability. At the indicated temperature change, the inventive paper by itself has dimensional stability that is better than commercial papers based on p-aramid floc and much better than commercial m-aramid papers. The dimensional stability of the final composite structure based on the invented paper is very close to those based on papers with p-aramid floc and much better in comparison with dimensional stability of the composites based on aramid papers.

## Claims

1. Aramid paper comprising 50 to 95 weight percent p-aramid pulp and 5-50 weight percent of floc with an initial modulus less than 3000 cN/tex, wherein the floc is meta-aramid.

2. The aramid paper of claim 1, wherein p-aramid pulp is poly (p-phenylene terephthalamide) pulp.

3. The aramid paper of claim 1, wherein the meta-aramid floc is poly (m-phenylene isophthalamide) floc.

4. The aramid paper of claim 1, comprising a polymer binder material in the quantity of less than 20 weight percent based on the weight of the total composition.

5. The aramid paper of claim 4, wherein at least a portion of the polymer binder material is in the form of fibrids.

6. The aramid paper of claim 5, wherein the fibrids are made from poly (m-phenylene isophthalamide).

7. The aramid paper of claim 4, wherein the polymer binder can be fused by one of the group consisting of drying and calendering.

8. The aramid paper of claim 4, wherein at least a portion of the polymer binder material is a resin binder material, which can be fused during drying or calendering of the paper.

9. The aramid paper of claim 8, wherein at least a portion of the resin binder material is thermoplastic floc.

10. The aramid paper of claim 8, wherein at least a portion of the resin binder material is a water-soluble resin.

11. The aramid paper of claim 1, wherein the basis weight of the paper is less than 70 g/m².

12. The aramid paper of claim 1 or 4, wherein the absolute value of the coefficient of thermal expansion of the paper in plane in the temperature interval between 20 and 100°C is less than 4 ppm/C.

13. The aramid paper of claim 1 or 4, comprising 70 to 95 weight percent p-aramid pulp.

14. A printed wiring board, comprising one or more layers of the paper of claim 1 or 4.

15. An electrical insulating material, comprising one or more layers of the paper of claim 1 or 4.

16. A composite structure, comprising the aramid paper of claim 1 or 4 impregnated with a resin.

17. The composite structure of claim 16, wherein the resin is a phenol.

18. A printed wiring board or electrical insulating material, comprising the composite structure of claim 16.

19. A structural material, comprising the aramid paper of claim 1 or 4, and
wherein the aramid paper is incorporated into the cells of a honeycomb structure, or
wherein the aramid paper is incorporated into the facing of a sandwich panel.

20. A process of making an aramid paper as defined in claim 1 comprising the steps of dispersing p-aramid pulp in water
blending the pulp/water slurry with a floc having an initial modulus less than 3000 cN/tex wherein the weight percent of the pulp and the floc in the solids is from 50 to 95 and from 5 to 50 respectively,
draining the water from the final slurry to yield a wet paper composition,
drying the wet paper composition.

21. The process of claim 20, comprising a step of wet pressing of the wet paper composition before drying.

22. The process of claim 21, comprising heat-treating the paper after drying.

23. The process of claim 20, comprising a step of adding a polymer binder material in a quantity less than 20 weight percent of the total solids after blending the pulp/water slurry with the floc.

24. The process of claim 23, comprising heat-tremng the paper after drying.

25. The process of claim 20, comprising densification of the dried paper.

26. The process of claim 25, wherein densification is performed by selecting one of the group consisting of application of pressure in the nip of a calender and application of pressure in a press.

27. The process of claim 25, comprising a step of heat-treating the paper after densification.

## Patentansprüche

1. Aramidpapier, 50 bis 95 Gewichtsprozent p-Aramidpulpe und 5-50 Gewichtsprozent Flocke mit einem anfänglichen Modul von weniger als 3000 cN/tex umfassend, wobei die Flocke Meta-Aramid ist.

2. Aramidpapier nach Anspruch 1, wobei die p-Aramidpulpe Poly(p-phenylenterepthalamid)-Pulpe ist.

3. Aramidpapier nach Anspruch 1, wobei die Meta-Aramidflocke Poly(m-phenylenisopthalamid)-Flocke ist.

4. Aramidpapier nach Anspruch 1, ein Polymerbindemittelmaterial in der Menge von weniger als 20 Gewichtsprozent, auf das Gewicht der gesamten Zusammensetzung bezogen, umfassend.

5. Aramidpapier nach Anspruch 4, wobei mindestens ein Teil des Polymerbindemittelmaterials in Form von Fibriden vorliegt.

6. Aramidpapier nach Anspruch 5, wobei die Fibride aus Poly(m-phenylenisopthalamid) hergestellt sind.

7. Aramidpapier nach Anspruch 4, wobei das Polymerbindemittel durch eines der Gruppe bestehend aus Trocknen und Kalandrieren fusioniert werden kann.

8. Aramidpapier nach Anspruch 4, wobei mindestens ein Teil des Polymerbindemittelmaterials ein Harzbindemittelmaterial ist, das während des Trocknens oder Kalandrierens des Papiers fusioniert werden kann.

9. Aramidpapier nach Anspruch 8, wobei mindestens ein Teil des Harzbindemittelmaterials thermoplastische Flocke ist.

10. Aramidpapier nach Anspruch 8, wobei mindestens ein Teil des Harzbindemittelmaterials ein wasserlösliches Harz ist.

11. Aramidpapier nach Anspruch 1, wobei das Flächengewicht des Papiers weniger als 70 g/m² beträgt.

12. Aramidpapier nach Anspruch 1 oder 4, wobei der absolute Wert des Wärmedehnungskoeffizienten des Papiers in der Ebene im Temperaturbereich zwischen 20 und 100°C weniger als 4 ppm/C beträgt.

13. Aramidpapier nach Anspruch 1 oder 4, 70 bis 95 Gewichtsprozent p-Aramidpulpe umfassend.

14. Leiterplatte, eine oder mehrere Schichten des Papiers nach Anspruch 1 oder 4 umfassend.

15. Elektrisches Isoliermaterial, eine oder mehrere Schichten des Papiers nach Anspruch 1 oder 4 umfassend.

16. Verbundbauelement, das Aramidpapier nach Anspruch 1 oder 4, das mit einem Harz imprägniert ist, umfassend.

17. Verbundbauelement nach Anspruch 16, wobei das Harz ein Phenol ist.

18. Leiterplatte oder elektrisches Isoliermaterial, das Verbundbauelement nach Anspruch 16 umfassend.

19. Konstruktionsmaterial, das Aramidpapier nach Anspruch 1 oder 4 umfassend und wobei das Aramidpapier in die Zellen eines Wabenbauelements eingearbeitet ist oder wobei das Aramidpapier in die Vorderseite einer Sandwichplatte eingearbeitet ist.

20. Verfahren zum Herstellen eines Aramidpapiers wie in Anspruch 1 definiert, die Schritte umfassend des
Dispergierens von p-Aramidpulpe in Wasser
Mischens der Pulpe-/Wasseraufschlämmung mit einer Flocke, die einen anfänglichen Modul von weniger als 3000 cN/tex aufweist, wobei der Gewichtsprozentsatz der Pulpe und der Flocke in den Feststoffen 50 bis 95 bzw. 5 bis 50 beträgt,
Ablassens des Wassers aus der endgültigen Aufschlämmung, um eine nasse Papierzusammensetzung zu ergeben,
Trocknens der nassen Papierzusammensetzung.

21. Verfahren nach Anspruch 20, einen Schritt des Nasspressens der nassen Papierzusammensetzung vor dem Trocknen umfassend.

22. Verfahren nach Anspruch 21, das Hitzebehandeln des Papiers nach dem Trocknen umfassend.

23. Verfahren nach Anspruch 20, einen Schritt des Zusetzens eines Polymerbindemittelmaterials in einer Menge von weniger als 20 Gewichtsprozent, auf die gesamten Feststoffe bezogen, nach dem Mischen der Pulpe-/Wasseraufschlämmung mit der Flocke umfassend.

24. Verfahren nach Anspruch 23, das Hitzebehandeln des Papiers nach dem Trocknen umfassend.

25. Verfahren nach Anspruch 20, das Verdichten des getrockneten Papiers umfassend.

26. Verfahren nach Anspruch 25, wobei das Verdichten durch Auswählen eines der Gruppe bestehend aus Aufbringen von Druck in den Spalt eines Kalanders und Aufbringen von Druck in einer Presse durchgeführt wird.

27. Verfahren nach Anspruch 25, den Schritt des Hitzebehandelns des Papiers nach dem Verdichten umfassend.

## Revendications

1. Papier d'aramide comprenant 50 à 95 pourcents en poids de pâte de p*-aramide* et 5 à 50 pourcents en poids de floc avec un module initial inférieur à 3000 cN/tex, dans lequel le floc est du méta-aramide.

2. Papier d'aramide selon la revendication 1, dans lequel la pâte de *p-aramide* est une pâte de poly(téréphtalamide de *p-phénylène).*

3. Papier d'aramide selon la revendication 1, dans lequel le floc de méta-aramide est du floc de poly(isophtalamide de m*-phénylène).*

4. Papier d'aramide selon la revendication 1, comprenant un matériau liant polymère en la quantité inférieure à 20 pourcents en poids sur la base du poids de la composition totale.

5. Papier d'aramide selon la revendication 4, dans lequel au moins une portion du matériau liant polymère se présente sous la forme de fibrides.

6. Papier d'aramide selon la revendication 5, dans lequel les fibrides sont constitués de poly(isophtalamide de m*-phénylène).*

7. Papier d'aramide selon la revendication 4, dans lequel le liant polymère peut être fusionné par l'une des opérations du groupe constitué du séchage et du calandrage.

8. Papier d'aramide selon la revendication 4, dans lequel au moins une portion du matériau liant polymère est un matériau liant de type résine, qui peut être fusionné durant le séchage ou le calandrage du papier.

9. Papier d'aramide selon la revendication 8, dans lequel au moins une portion du matériau liant de type résine est un floc thermoplastique.

10. Papier d'aramide selon la revendication 8, dans lequel au moins une portion du matériau liant de type résine est une résine soluble dans l'eau.

11. Papier d'aramide selon la revendication 1, dans lequel le poids de base du papier est inférieur à 70 g/m².

12. Papier d'aramide selon la revendication 1 ou 4, dans lequel la valeur absolue du coefficient d'expansion thermique du papier dans le plan dans l'intervalle de température entre 20 et 100°C est inférieure à 4 ppm/°C.

13. Papier d'aramide selon la revendication 1 ou 4, comprenant 70 à 95 pourcents en poids de pâte de *p-aramide.*

14. Carte à circuits imprimés, comprenant une ou plusieurs couche(s) du papier selon la revendication 1 ou 4.

15. Matériau d'isolation électrique, comprenant une ou plusieurs couche(s) du papier selon la revendication 1 ou 4.

16. Structure composite, comprenant le papier d'aramide selon la revendication 1 ou 4 imprégné d'une résine.

17. Structure composite selon la revendication 16, dans laquelle la résine est un phénol.

18. Carte à circuits imprimés ou matériau d'isolation électrique, comprenant la structure composite selon la revendication 16.

19. Matériau structurel, comprenant le papier d'aramide selon la revendication 1 ou 4, et dans lequel le papier d'aramide est incorporé dans les alvéoles d'une structure en nid d'abeille, ou dans lequel le papier d'aramide est incorporé à l'avant d'un panneau sandwich.

20. Procédé de fabrication d'un papier d'aramide tel que défini selon la revendication 1 comprenant les étapes de
dispersion de la pâte de *p-aramide* dans de l'eau,
mélange de la suspension de pâte/eau avec un floc ayant un module initial inférieur à 3000 cN/tex dans lequel le pourcentage en poids de la pâte et du floc dans les matières solides est de 50 à 95 et de 5 à 50 respectivement,
égouttage de l'eau de la suspension finale pour produire une composition de papier humide,
séchage de la composition de papier humide.

21. Procédé selon la revendication 20, comprenant une étape de pressage à l'état humide de la composition de papier humide avant le séchage.

22. Procédé selon la revendication 21, comprenant le traitement thermique du papier après séchage.

23. Procédé selon la revendication 20, comprenant une étape d'addition d'un matériau liant polymère en une quantité inférieure à 20 % en poids des matières solides totales après mélange de la suspension de pâte/eau avec le floc.

24. Procédé selon la revendication 23, comprenant le traitement thermique du papier après séchage.

25. Procédé selon la revendication 20, comprenant la densification du papier séché.

26. Procédé selon la revendication 25, dans lequel la densification est effectuée par la sélection d'une opération du groupe constitué de l'application d'une pression dans l'espace d'une calandreuse et l'application d'une pression dans une presse.

27. Procédé selon la revendication 25, comprenant une étape de traitement thermique du papier après densification.
